# NEW EUROPEAN PATENT SPECIFICATION

(11) **EP 0 676 817 B2**
(45) Date of publication and mention of the opposition decision: **09.06.2004**
(45) Mention of the grant of the patent: 09.09.1998
(21) Application number: 95105193.7
(22) Date of filing: 06.04.1995
(51) Int. Cl.: H01L 39/24

(54) **Method of preparing high-temperature superconducting wire**
Verfahren zum Herstellen eines supraleitenden Hochtemperaturdrahtes
Procédé de fabrication d'un fil supraconducteur à haute température

(30) Priority: 07.04.1994 JP 6918394
(43) Date of publication of application: 11.10.1995
(73) Proprietor: SUMITOMO ELECTRIC INDUSTRIES, LTD., Osaka-shi, Osaka 541 (JP); Japan Science and Technology Corporation, Kawaguchi-shi, Saitama (JP)
(72) Inventor: Ueyama, Munetsugu, c/o Osaka Works of, Konohana-ku, Osaka-shi, Osaka (JP); Sato, Kenichi, c/o Osaka Works of, Konohana-ku, Osaka-shi, Osaka (JP)
(74) Representative: Winter, Brandl, Fürniss, Hübner, Röss, Kaiser, Polte Partnerschaft

(56) References cited:
- EP-A- 0 281 444
- EP-A- 0 290 331
- EP-A- 0 356 969
- EP-A- 0 451 532
- EP-A- 0 462 409
- EP-A- 0 467 237
- EP-A- 0 475 315
- EP-A- 0 496 281
- EP-A- 0 504 909
- EP-A- 0 551 523
- DE-A- 4 124 980
- Physica C, Vol. 220, 1994, pp. 81-92
- IEEE Transactions on Applied Superconductivity, Vol. 3, No. 1, March 1993, pp. 942-945
- Applied Superconductivity 1993, Vol. 1, H.C. Freyhardt (ed.), DGM Informationsgesellschaft Verlag, pp. 217-220
- Materials Research Society Symposium-Proceedings, Vol. 275, 1992, Materials Research Society, pp. 233-238
- Applied Physics Letter, Vol. 59, No. 6, 5 Aug. 1991, pp. 736-738
- Advances in Superconductivity II, Proceedings of the 2nd International Symposium on Superconductivity (ISS'89), November 14-17, 1989, Tsukuba (Japan), T. Ishiguro and K. Kajimura (eds.), Springer-Verlag 1990, pp. 419-422

## Description

### BACKGROUND OF THE INVENTION

### Field of the Invention

The present invention relates to a method of preparing an oxide superconducting wire, and more particularly, it relates to a method of preparing an oxide superconducting wire having a high critical current density.

### Description of the Background Art

In recent years, ceramics-based superconducting materials, i.e., oxide superconducting materials, are watched with interest as superconducting materials exhibiting higher critical temperatures. Among such materials, yttrium-, bismuth- and thallium-based superconducting materials exhibit high critical temperatures of about 90 K, 110 K and 120 K respectively, and practical applications thereof are expected.

As to these oxide superconducting materials, study has been made on processes of preparing wires. A process of working an oxide superconducting material into a wire in a solid phase state basically includes the steps of charging raw material powder for superconductor in a metal sheath of silver or the like, carrying out drawing and rolling thereon, and carrying out a heat treatment for forming a sintered body with respect to the superconducting material. It is known that a wire having a higher critical current density is obtained by a further heat treatment for rolling and sintering which is carried out after the heat treatment step of forming the sintered body in the aforementioned process.

An oxide superconducting wire must have a high critical current density in addition to a high critical temperature, so that the same is applied to a cable or a magnet. Further, a long oxide superconducting wire must have homogeneous characteristics, particularly homogeneous superconductivity.

EP-A-0475 315 discloses a method of preparing an oxide high-temperature superconductor. The powdery raw material is filled in a metal sheath and the filled sheath is heat treated during two hours to discharge the generated gases, mainly CO₂.

Applied Superconductivity 1993, Vol. 1, pages 217-220 Vol 1, A. C. Everyhandt discloses a powder-in-tube-process where a non-superconductive oxide is heated to develope the 2212-phase which afterwards is heat-treated at 800-840°C in air with intermediate cold pressing.

IEEE Transactions on Applied Superconductivity, March 1993, vol. 3 No.1, pages 942-945 discloses an initial wire annealing step at 790°C for 8 hours followed by rolling and heat treatment sequences.

### SUMMARY OF THE INVENTION

An object of the present invention is to provide a method which can prepare an oxide superconducting wire having a further improved critical current density, in order to satisfy the aforementioned requirements.

The method, of preparing a high-temperature superconducting wire, according to the present invention comprises the steps defined in claim 1.

Preferred embodiments of the method of preparing a high temperature superconducting wire of the present invention are disclosed and claimed in the subclaims 2 to 5.

No sintered body is substantially formed by the heat treatment at the low temperature, while the critical current density of the finally obtained high-temperature superconducting wire is increased as compared with a case of carrying out no such heat treatment, due the heat treatment at the low temperature.

In a conventional method, a sintering step for forming a sintered body of an oxide superconductor is carried out immediately after plastic working. According to the present invention, on the other hand, the wire is previously heat treated at the temperature which is lower than the sintering temperature in advance of the sintering step, thereby remarkably improving the critical current density of the finally obtained superconducting wire, as hereafter described in more concrete terms. The degree of improvement of the critical current density, which depends on the structure of the prepared wire and conditions for preparing the same, is about 1.2 times at the least, and may be up to about 1.8 to 2.0 times.

The method according to the present invention is used for forming a wire having a bismuth (Bi)-based oxide superconductor. In a case of forming a wire which is related to a Bi-based ceramics superconductor, the method according to the present invention comprises the steps of charging raw material powder having an element composition capable of forming a 2223 phase of a Bi-based oxide superconductor and mainly consisting essentially of a 2212 phase of the Bi-based oxide superconductor and a non-superconducting phase in a metal sheath, carrying out plastic working on the metal sheath which is charged with the raw material powder for obtaining a tape wire, carrying out a heat treatment at a first temperature on the obtained tape wire, and carrying out a heat treatment at a second temperature, which is higher than the first temperature, on the wire obtained by said heat treatment at the first temperature, wherein the first temperature substantially forms neither a 2223 phase of the Bi-based oxide superconductor nor a sintered body thereof while the second temperature forms a 2223 phase of the Bi-based oxide superconductor and a sintered body thereof, and the heat treatment at the first temperature provides the finally obtained wire with a critical current density which is higher than that in a case of carrying out no such heat treatment.

In a case of a Bi-Sr-Ca-Cu-O-based superconductor, for example, the 2223 phase of the Bi-based oxide superconductor has a composition of Bi₂Sr₂Ca₂Cu₃O₁₀₋ₓ (0 ≤ X < 1 ), while the 2212 phase thereof has a composition of Bi₂Sr₂Ca₁Cu₂O₈₋ₓ (0 ≤ X < 1 ). In a case of (Bi, Pb)-Sr-Ca-Cu-O-based superconductor, on the other hand, the 2223 phase of the Bi-based oxide superconductor has a composition of (Bi, Pb)₂Sr₂Ca₂Cu₃O_{10-X} (0 ≤ X < 1 ), while the 2212 phase thereof has a composition of (Bi, Pb)₂Sr₂Ca₁ CU₂O_{8-X} (0 ≤ X < 1) The non-superconducting phase may have a composition such as Sr-Ca-Cu-O, (Ca, Sr)-Pb-O, or Ca-Cu-O.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig.1 illustrates the result of X-ray diffraction measurement which was made on a wire not yet subjected to a first heat treatment according to the present invention;
Fig. 2 illustrates the result of X-ray diffraction measurement which was made on a wire immediately after the same was subjected to the first heat treatment according to the present invention; and
Fig. illustrates relations between first heat treatment temperatures and critical current densities of wires in relation to samples obtained in Example 1.

### DESCRIPTION OF THE PREFERRED EMBODIMENTS,

In a process of the present invention, powder as defined in claim 1 can be obtained by mixing powder materials of oxides and/or carbonates of elements for forming the superconductor in prescribed compounding ratios, sintering the mixture, and crushing the sintered substance. A metal sheath to be charged with the obtained powder can consist essentially of at least one stabilizing material which is selected from the group consisting of silver and a silver alloy, for example. The stabilized metal sheath which is charged with the powder is subjected to plastic working. This plastic working includes extrusion, drawing, rolling etc., for example. The rolling can provide a tape-shaped superconducting wire. The wire obtained by the plastic working is subjected to a first heat treatment at a low temperature, and a second heat treatment at a high temperature, in accordance with the present invention.

According to the present invention, the first heat treatment, i.e., the heat treatment in advance of sintering, is carried out at a temperature in the range of 700 to 800°C.

If the temperature is lower than 600°C, it is difficult to attain the aforementioned remarkable improvement of the critical current density. In order to attain a desired effect within a treatment time of 10 to 50 hours, in consideration of wire production efficiency, a temperature of 700 to 800°C is necessary. The object of the present invention can be attained by the heat treatment at 700 to 800°C, as understood from Examples described later. In this temperature range, the heat treatment is carried out for 10 to 50 hours According to the present invention, this time is selected in consideration of the wire production efficiency, and can bring improvement of the critical current density at the temperature of 700 to 800 °C.

However, the time for the first heat treatment can be properly varied in response to the heating temperature and conditions for preparing the wire. In general, the range of the heating time which is required for attaining the object of the present invention tends to be reduced when a high temperature is employed, while the required treatment time tends to be lengthened when a low temperature is employed. A higher temperature is not necessarily preferable but a proper temperature and a proper time can be appropriately selected in response to the structure of the wire and the conditions for preparing the same.

According to the present invention, the first heat treatment can be preferably carried out in the atmosphere or under reduced pressure.

According to the present invention, the second heat treatment is carried out afterthe first heat treatment, for forming a sintered body with respect to the oxide superconductor. In a case of preparing a Bi-based oxide superconducting wire, a ceramics superconductor of a 2223 phase is formed from the 2212 phase and the non-superconducting phase in the wire. The second heat treatment is carried out at a temperature which is higher than 800°C, preferably in the range of 830 to 860°C, more preferably in the range of 840 to 850°C, for example. The second heat treatment can be preferably carried out in the atmosphere, or in a low oxygen atmosphere.

After the first heat treatment, the second heat treatment may be carried out either intermittently or continuously When the second heat treatment is intermittently carried out, a cooling step can be interposed between these treatments. In the cooling step, the wire can be cooled to the room temperature, for example. When these steps are continuously carried out, on the other hand, the second heat treatment can be carried out while increasing the temperature as such after completion of the first heat treatment. While the cooling step is preferably interposed in order to obtain a higher critical current density, the object of the present invention can be attained in either method.

In order to attain excellent superconductivity, plastic working (rolling) and sintering are further carried out after the sintering step. The plastic working (rolling) and the subsequent sintering can be repeated a plurality of times. In this case, the first heat treatment may be carried out once in advance of the first sintering step, in order to improve the critical current density. According to the present invention, however, the treatment at the temperature which is lower than the sintering temperature is not restricted to once but may be carried out a plurality of times. Also in this case, the heat treatment at the low temperature is necessarily carried out in advance of the sintering step.

According to the present invention, the plastic working includes drawing and rolling. Further, the metal sheath which is employed in the present invention is preferably prepared from a sheath consisting essentially of a noble metal or a noble metal alloy such as silver or a silver alloy. According to the present invention, a superconducting wire having a critical current density exceeding 30,000 A/cm² can be readily prepared as understood from Examples described later.

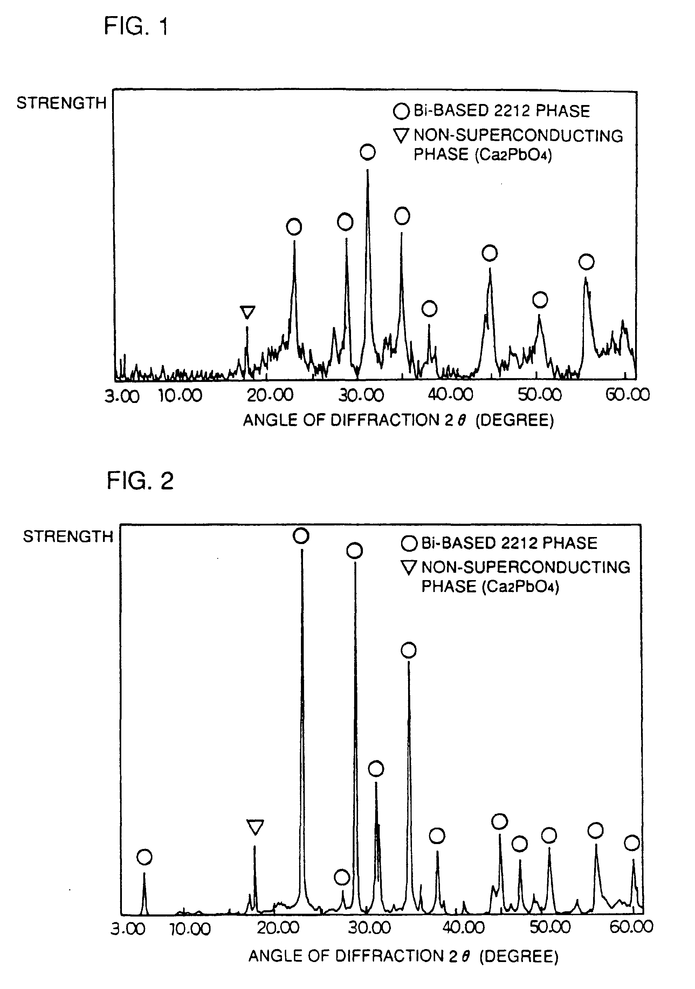

Oxides and carbonates were mixed with each other to provide a composition of Bi:Pb:Sr:Ca:Cu = 1.8:0.4:2.0:2.2: 3.0, and the mixture was sintered by a heat treatment and thereafter crushed, thereby preparing powder mainly consisting essentially of a 2212 phase and a non-superconducting phase. Then, this powder was charged in a silver pipe of 12.0 mm in outer diameter and 10.0 mm in inner diameter and thereafter subjected to drawing and rolling, thereby preparing a tape wire. X-ray diffraction measurement was made on the powder in the interior of the obtained wire, to obtain a chart shown in Fig. 1. Since the obtained chart was broad, it was supposed that the plastic working exerted some influence on the charged powder to bring the powder into an amorphous state.

On the other hand, a wire which was obtained after rolling was heated under conditions for forming no sintered body, e.g., at a temperature of 700 to 800°C, according to the present invention. Then, X-ray diffraction measurement was made on the powder in the interior of the wire, to obtain a chart shown in Fig. 2. This chart exhibits no broad peaks appearing in Fig. 1. Thus, it was supposed that an amorphous state may have been converted to a crystalline state, for example, with removal of an influence which was exerted in the plastic working. It has been clarified that a wire which is heat treated at a sintering temperature after the same is subjected to a heat treatment at a low temperature has a higher critical current density than a wire which is sintered with no heat treatment at a low temperature, as understood from the following Examples.

These facts have been clarified in the experiments on the wires employing bismuth-based superconductors, and it has been supposed that the heat treatment at a low temperature in advance of the sintering can remove a bad influence which is exerted by the plastic working on the wire also in another oxide superconductor and under other conditions, whereby a wire having a high critical current density can be finally provided.

### Examples

### Example 1

Oxides and carbonates were mixed with each other to provide a composition of Bi:Pb:Sr:Ca:Cu = 1.8:0.4:2.0:2.2: 3.0, and the mixture was sintered by a heat treatment and thereafter crushed, thereby preparing powder mainly consisting essentially of a 2212 phase and a non-superconducting phase. Then, this powder was charged in a silver pipe of 12.0 mm in outer diameter and 10.0 mm in inner diameter and thereafter subjected to drawing and rolling, thereby preparing a tape wire. Six wires of 10 cm in length were cut out from this tape wire, and heat treated under the following conditions respectively:
Sample 1: at 600°C for 10 hours
Sample 2: at 650°C for 10 hours
Sample 3: at 700°C for 10 hours
Sample 4: at 750°C for 10 hours
Sample 5: at 800°C for 10 hours
Sample 6: allowed to stand under the room temperature

Thereafter the samples were cooled to the room temperature once, then sintered at 845°C for 50 hours, subjected to rolling again, and sintered at 840°C for 50 hours. Critical currents and critical current densities of the obtained wires were measured respectively. The sample 6 which was allowed to stand under the room temperature can be regarded as a sample which was sintered after rolling with no low-temperature heat treatment according to the present invention. Table 1 shows the results.

**Table 1**

| Sample No. | Critical Current (A) | Critical Current Density (A/cm²) |
|---|---|---|
| 1 | 24 | 24,000 |
| 2 | 26 | 26,000 |
| 3 | 28 | 28,000 |
| 4 | 30 | 30,000 |
| 5 | 30 | 30,000 |
| 6 | 20 | 20,000 |

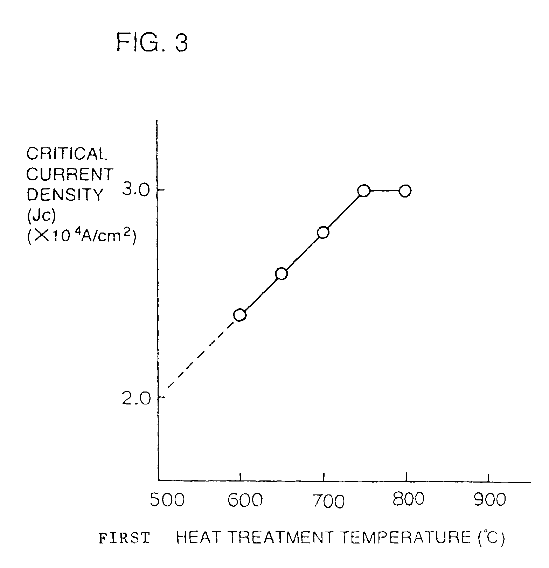

The above results are plotted in Fig. 3. It is recognized that the critical current density of the finally obtained wire is increased as the temperature of the intermediate heat treatment is raised from 600°C, and the effect is saturated at 750°C. The critical current density is also improved at 800°C, while the obtained critical current density is reduced when sintering is carried out with no intermediate heat treatment after plastic working. On the other hand, it is supposed that no remarkable effect (remarkable increase of the critical current density) is attained when the temperature for the intermediate heat treatment is below 600°C.

It has been clarified from the aforementioned results that a wire having a higher critical current density can be obtained according to the present invention.

### Example 2

Powder was prepared similarly to Example 1, charged in a silver pipe, and thereafter subjected to drawing. The wire was cut after the drawing to obtain 61 wires, which were bundled and charged in a silver pipe of 12.0 mm in outer diameter and 10.0 mm in inner diameter, and again subjected to drawing and rolling. Three multifilamentary wires of 100 m in length were prepared through the aforementioned steps. Two of the obtained wires were heat treated under conditions of 700°C and 20 hours (sample 7) and 760°C and 20 hours (sample 8) respectively. Then, these samples were further heated as such with no cooling, and sintered under conditions of 845°C and 50 hours. The remaining wire (sample 9) was sintered at 845°C for 50 hours, thereafter subjected to rolling, and then sintered at 840°C for 50 hours. Critical currents and critical current densities were measured as to the respective samples. Table 2 shows the results.

**Table 2**

| Sample No. | Critical Current (A) | Critical Current Density (A/cm²) |
|---|---|---|
| 7 | 19 | 17,300 |
| 8 | 23 | 21,000 |
| 9 | 15 | 13,600 |

It has been clarified from the above results that a wire having a higher critical current density can be prepared according to the present invention.

### Example 3

Oxides and carbonates were mixed with each other to provide a composition of Bi:Pb:Sr:Ca:Cu = 1.82:0.31:1.89: 1.99:3.02, and the mixture was sintered by a heat treatment and thereafter crushed, thereby preparing powder mainly consisting essentially of a 2212 phase and a non-superconducting phase. Then, this powder was charged in a silver pipe of 12.0 mm in outer diameter and 10.0 mm in inner diameter and thereafter subjected to drawing and rolling, thereby preparing a tape wire. Six wires of 10 cm in length were cut out from the obtained tape wire, and heat treated under the following conditions respectively:
Samples 10 and 11: at 700°C for 10 hours in a vacuum of 1 Torr
Samples 12 and 13: at 760°C for 10 hours in the atmosphere
Samples 14 and 15: allowed to stand under the room temperature

Thereafter the samples were cooled to the room temperature once. Then, the respective samples were sintered at 845°C for 50 hours, subjected to rolling again, and thereafter sintered at 840°C for 50 hours. Critical currents and critical current densities of the obtained wires were measured respectively. Table 3 shows the results.

**Table 3**

| Sample No. | Critical Current (A) | Critical Current Density (A/cm²) |
|---|---|---|
| 10 | 35 | 38,900 |
| 11 | 34 | 37,800 |
| 12 | 28 | 31,100 |
| 13 | 27 | 30,000 |
| 14 | 20 | 22,000 |
| 15 | 21 | 23,300 |

It has been clarified from the above results that a wire having a higher critical current density can be prepared according to the present invention, and that the object of the present invention can be attained by carrying out the heat treatment either in a vacuum or in the atmosphere.

As hereinabove described, an oxide high-temperature superconducting wire having a higher critical current density and superior superconductivity can be prepared according to the present invention.

## Claims

1. A method of preparing a high-temperature superconducting wire, comprising the steps of:
charging raw material powder having an element composition capable of forming a 2223 phase of a bismuth-based oxide superconductor and mainly consisting essentially of a 2212 phase and a non-superconducting phase in a metal sheath;
carrying out plastic working on said metal sheath being charged with said powder for obtaining a wire;
carrying out a heat treatment at a first temperature on said obtained wire;
optionally cooling said wire obtained by said heat treatment at the first temperature to room temperature
carrying out a heat treatment at a second temperature, being higher than said first temperature, on said wire obtained by said heat treatment at the first temperature, or in case the cooling is performed after the first heat treatment, on the wire obtained by said cooling step,
wherein
said heat treatment at said first temperature is carried out at a temperature in the range of 700 to 800 °C during 10 to 50 hours and substantially forms no sintered body of said oxide superconductor, said heat treatment at said second temperature being carried out at a temperature higher than 800 °C and forming a sintered body of said oxide superconductor, and
the critical current density of the finally obtained high-temperature superconducting wire is increased by said heat treatment at said first temperature as compared with a case of not carrying out said heat treatment.

2. A method of preparing a high-temperature superconducting wire according to claim 1 comprising the steps of:
carrying out the plastic working on said metal sheath being charged with said raw material powder for obtaining a tape wire;
carrying out the heat treatment at the first temperature on the obtained said tape wire; and
carrying out the heat treatment at the second temperature carrying out plastic working on the wire after said heat treatment at said second temperature and then carrying out a third heat treatment for further sintering,
wherein
said heat treatment at said first temperature substantially forms neither a 2223 phase of said bismuth-based oxide superconductor nor a sintered body thereof, said heat treatment at said second temperature forming a 2223 phase of said bismuth-based oxide superconductor and a sintered body thereof.

3. The method in accordance with claim 1 or 2, further comprising a cooling step between said heat treatments at said first and second temperatures.

4. The method in accordance with claim 1 or 2, wherein said heat treatments at said first and second temperatures are continuously carried out with no interposition of a cooling step there between.

5. The method in accordance with any of claim 1 to 4, wherein the heat treatment at the first temperature is carried out under reduced pressure or in the atmosphere.

## Patentansprüche

1. Verfahren zur Herstellung eines Hochtemperatur-supraleitenden Drahtes, umfassend die folgenden Schritte:
Füllen von Rohmaterialpulver, welches eine Elementzusammensetzung, die zur Bildung einer 2223-Phase eines auf Bismuth basierenden Oxid-Supraleiters in der Lage ist, besitzt und hauptsächlich aus im wesentlichen einer 2212-Phase und einer nichtsupraleitenden Phase besteht, in eine Metallhülle;
Durchführen einer plastischen Verformung an der mit dem Pulver befüllten Metallhülle, um einen Draht zu erhalten;
Durchführen einer Wärmebehandlung bei einer ersten Temperatur an dem erhaltenen Draht;
gegebenenfalls Kühlen des Drahtes, der durch die Wärmebehandlung bei der ersten Temperatur erhalten wird, auf Raumtemperatur,
Durchführen einer Wärmebehandlung bei einer zweiten Temperatur, welche höher ist als die erste Temperatur, an dem Draht, der erhalten wird durch die Wärmebehandlung bei der ersten Temperatur, oder in dem Fall, daß nach der ersten Wärmebehandlung das Kühlen durchgeführt wird, an dem Draht, der durch den Kühlungsschritt erhalten wird, wobei
die Wärmebehandlung bei der ersten Temperatur bei einer Temperatur im Bereich von 700 bis 800°C während 10 bis 50 Stunden durchgeführt wird und im wesentlichen keinen Sinterkörper des Oxid-Supraleiters bildet, die Wärmebehandlung bei der zweiten Temperatur bei einer Temperatur von mehr als 800°C durchgeführt wird und einen Sinterkörper des Oxid-Supraleiters bildet, und
die kritische Stromdichte des letztendlich erhaltenen Hochtemperatur-supraleitenden Drahtes durch die Wärmebehandlung bei der ersten Temperatur gegenüber dem Fall des Nichtdurchführens der Wärmebehandlung erhöht ist.

2. Verfahren zur Herstellung eines Hochtemperatur-supraleitenden Drahtes nach Anspruch 1, umfassend die folgenden Schritte:
Durchführen der plastischen Verformung an der mit dem Rohmaterialpulver befüllten Metallhülle, um einen Banddraht zu erhalten;
Durchführen der Wärmebehandlung bei der ersten Temperatur an dem erhaltenen Banddraht; und
Durchführen der Wärmebehandlung bei der zweiten Temperatur, Durchführen einer plastischen Verformung an dem Draht nach der Wärmebehandlung bei der zweiten Temperatur und dann Durchführen einer dritten Wärmebehandlung für ein weiteres Sintern wobei
die Wärmebehandlung bei der ersten Temperatur im wesentlichen weder eine 2223-Phase des auf Bismuth basierenden Oxid-Supraleiters noch einen Sinterkörper davon bildet, die Wärmebehandlung bei der zweiten Temperatur eine 2223-Phase des auf Bismuth basierenden Oxid-Supraleiters und einen Sinterkörper davon bildet.

3. Verfahren nach Anspruch 1 oder 2, welches ferner einen Kühlungsschritt zwischen den Wärmebehandlungen bei der ersten und zweiten Temperatur umfaßt.

4. Verfahren nach Anspruch 1 oder 2, wobei die Wärmebehandlungen bei der ersten und zweiten Temperatur kontinuierlich durchgeführt werden, ohne einem Dazwischenschalten eines Kühlschrittes.

5. Verfahren nach einem der Ansprüche 1 bis 4, wobei die Wärmebehandlung bei der ersten Temperatur unter einem reduzierten Druck oder in der Atmosphäre durchgeführt wird.

## Revendications

1. Procédé de préparation d'un fil supraconducteur à haute température, comportant les étapes consistant à :
charger une poudre de matière première ayant une composition en élément capable de former une phase 2223 d'un supraconducteur à base d'oxyde à base de bismuth et consistant principalement essentiellement en une phase 2212 et une phase non-superconductrice dans une gaine en métal ;
réaliser un travail plastique sur ladite gaine en métal qui est chargée avec ladite poudre afin d'obtenir un fil ;
réaliser un traitement thermique à une première température sur ledit fil obtenu ; refroidir éventuellement ledit fil obtenu par ledit traitement thermique à la première température à la température ambiante ;
réaliser un traitement thermique à une deuxième température, qui est plus élevée que la ladite première température, sur ledit fil obtenu par ledit traitement thermique à la première température ou dans le cas où le refroidissement est réalisé après le premier traitement thermique, sur le fil obtenu par ladite étape de refroidissement ; dans lequel
ledit traitement thermique à ladite première température est effectué à une température dans la plage de 700 à 800°C pendant 10 à 50 heures et ne forme sensiblement aucun corps fritté dudit supraconducteur à base d'oxyde, ledit traitement thermique à ladite deuxième température étant effectué à une température supérieure à 800°C et formant un corps fritté dudit supraconducteur à base d'oxyde, et
la densité de courant critique du fil supraconducteur à haute température finalement obtenu est augmentée par ledit traitement thermique à ladite première température par rapport à un cas sans réalisation dudit traitement thermique.

2. Procédé de préparation d'un fil supraconducteur à haute température selon la revendication 1, comportant les étapes consistant à :
réaliser le travail plastique sur ladite gaine en métal qui est chargée avec ladite poudre de matière première pour obtenir un fil en ruban ;
réaliser le traitement thermique à la première température sur ledit fil en ruban obtenu ; et
réaliser le traitement thermique à la deuxième température en réalisant le travail plastique sur le fil après ledit traitement thermique à ladite deuxième température et en réalisant ensuite un troisième traitement thermique pour un frittage supplémentaire, dans lequel
ledit traitement thermique à ladite première température ne forme sensiblement ni une phase 2223 dudit supraconducteur à base d'oxyde à base de bismuth ni un corps fritté de celui-ci, ledit traitement thermique à ladite deuxième température formant une phase 2223 dudit supraconducteur à base d'oxyde de bismuth et un corps fritté de celui-ci.

3. Procédé selon la revendication 1 ou 2, comportant, en outre, une étape de refroidissement entre lesdits traitements thermiques auxdites première et deuxième températures.

4. Procédé selon la revendication 1 ou 2, dans lequel lesdits traitements thermiques auxdites première et deuxième températures sont réalisés en continu sans aucune interposition d'une étape de refroidissement entre eux.

5. Procédé selon l'une quelconque des revendications 1 à 4, dans lequel le traitement thermique à la première température est effectué à pression réduite ou dans l'atmosphère.
